# EUROPEAN PATENT SPECIFICATION

(11) **EP 3 968 371 B1**
(45) Date of publication and mention of the grant of the patent: **28.06.2023**
(21) Application number: 20896064.1
(22) Date of filing: 16.07.2020
(51) Int. Cl.: H01L 21/768, H01L 21/285, H10B 12/00

(54) **SEMICONDUCTOR STRUCTURE AND MANUFACTURING METHOD THEREFOR**
HALBLEITERSTRUKTUR UND HERSTELLUNGSVERFAHREN DAFÜR
STRUCTURE SEMI-CONDUCTRICE ET SON PROCÉDÉ DE FABRICATION

(30) Priority: 06.12.2019 CN 201911239722
(43) Date of publication of application: 16.03.2022
(73) Proprietor: Changxin Memory Technologies, Inc., Hefei, Anhui 230601 (CN)
(72) Inventor: PING, Er Xuan, Hefei, Anhui 230601 (CN); ZHOU, Zhen, Hefei, Anhui 230601 (CN)
(74) Representative: Lavoix
(86) International application number: PCT/CN2020/102476
(87) International publication number: WO 2021/109580

(56) References cited:
- CN-U- 208 655 651
- CN-U- 208 767 278
- CN-U- 210 926 003
- KR-A- 20090 072 092
- US-A1- 2012 025 283
- US-A1- 2015 126 013
- US-A1- 2019 103 302
- US-A1- 2019 139 963

## Description

### CROSS REFERENCE

The present disclosure claims priority to Chinese Patent Application No. 201911239722.1, entitled "SEMICONDUCTOR STRUCTURE AND FABRICATION METHOD THEREOF" and filed on December 6, 2019.

### TECHNICAL FIELD

The present disclosure relates to the field of semiconductor fabrication technologies, and more particularly, to a semiconductor structure that can avoid forming air gaps and a fabrication method thereof.

### BACKGROUND

A storage node contact (SNC) structure is a contact structure for connecting transistors and storage capacitors in a DRAM structure. Generally, the SNC is a polycrystalline silicon. Generally, a bottom of the SNC is connected to a substrate and a shallow trench isolation (STI) structure, a top thereof is connected to metal, and sidewalls thereof are sidewalls of the isolation structure. The isolation structure is, for example, a bit line structure or a dielectric layer structure.

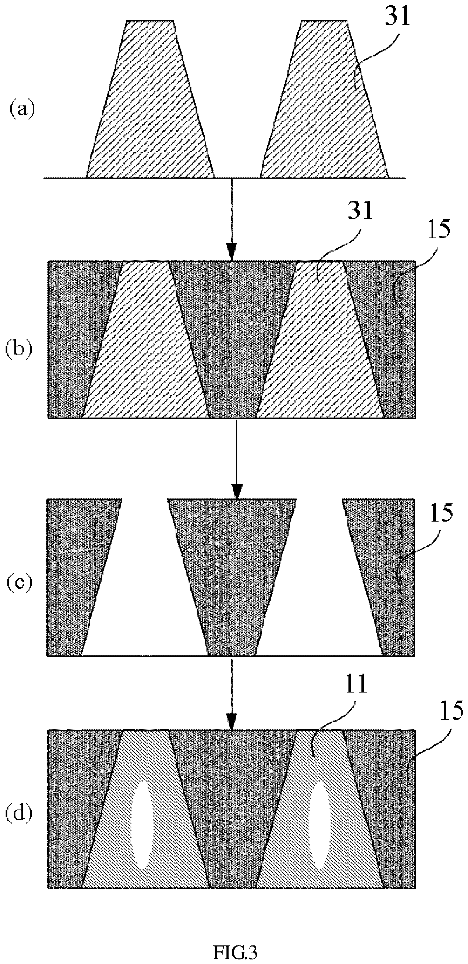

In the related technologies, the bit line structure is fabricated in advance, and thus it is required to fabricate the dielectric layer structure as the isolation structure to fabricate the other two sidewalls of the SNC trench, and the polycrystalline silicon is filled into the trench to fabricate the SNC. Due to larger hardness, the sidewalls of the dielectric layer can only be fabricated by deposition. As a result, the trench between the sidewalls of the dielectric layer formed by deposition is generally a trapezoidal structure (with reference to FIG. 3 of the specification), which is narrow at the top and wide at the bottom. Therefore, it is difficult to control uniformity of the deposition in the deposition process of the polycrystalline silicon, such that air gaps may be easily formed inside the SNC, which causes changes of electrical properties of the SNC, leads to component failure, and reduces the yield.

US2015126013A1 discloses a semiconductor device capable of reducing parasitic capacitance between adjacent conductive structures and a method for fabricating the same. The semiconductor device includes a number of bit line structures and each of which includes a first contact plug formed over a substrate and a bit line formed over the first contact plug. A spacer structure having air gaps is formed on sidewalls of the first contact plug and on sidewalls of the bit line. A plug isolation layer is formed between the number of bit line structures. The isolation layer includes an opening. A second contact plug is formed in the opening and a memory element is formed over the second contact plug.

US2019103302A1 relates to a method of fabricating a semiconductor device. A number of bit line structures is firstly formed over a semiconductor substrate. A line-type opening is formed between the bit line structures. A sacrificial spacer is formed on both sidewalls of the line-type opening. A line-type plug is formed to fill the line-type opening over the sacrificial spacer. A number of plug isolation openings that expose the sacrificial spacer is formed by etching a portion of the line-type plug in a direction crossing the bit line structures. A number of air gaps is formed by removing the exposed sacrificial spacer. A remaining line-type plug below the plug isolation openings is removed to form a number of island-type plugs. A plug isolation layer inside the plug isolation openings is formed to isolate neighboring island-type plugs from each other.

US2012025283A1 discloses that, in a semiconductor device having an enlarged contact area between a contact structure and a substrate, the substrate may include a first region on which a conductive structure is arranged and a second region defining the first region. The first region may include a multi-faced polyhedral recess of which at least one of the sidewalls is slanted with respect to a surface of the substrate. An insulation layer may be formed on the substrate to a thickness that is sufficient to cover the conductive structure. The insulation layer has a contact hole that may be communicated with the recess. The active region of the substrate is exposed through the contact hole. A conductive pattern is positioned in the recess and the contact hole. Accordingly, the contact resistance at the active region of the substrate may be kept to a relatively low value even though the gap distances and line width of pattern lines are reduced.

It should be noted that the information disclosed in above background art is only used to enhance the understanding of the background of the present disclosure. Therefore, information that does not constitute the prior art known to a person of ordinary skill in the art may be included.

### SUMMARY

An objective of the present disclosure is to provide a semiconductor structure and a fabrication method thereof, to overcome, at least to a certain extent, the problem of forming air gaps inside a polycrystalline silicon in the process of fabricating an SNC structure due to limitations of related technologies.

The invention is set out in the appended set of claims.

According to the embodiments of the present disclosure, an inclined plane is arranged in the exposed part of the active region at the bottom of the groove containing the SNC structure, and the polycrystalline silicon is grown inside the groove by taking the inclined plane as a substrate. In this way, the SNC structure containing no air gap can be quickly formed, a component failure rate can be reduced, and a yield rate can be enhanced.

It is to be understood that the above general description and the detailed description below are merely exemplary and explanatory, and do not limit the present disclosure.

### BRIEF DESCRIPTION OF THE DRAWINGS

The accompanying drawings herein are incorporated in and constitute a part of this specification, illustrate embodiments conforming to the present disclosure and, together with the specification, serve to explain the principles of the present disclosure. Apparently, the accompanying drawings in the following description show merely some embodiments of the present disclosure, and persons of ordinary skill in the art may still derive other drawings from these accompanying drawings without creative efforts.
FIG. 1 illustrates a schematic diagram of an arrangement mode of an SNC structure according to an exemplary embodiment of the present disclosure;
FIG. 2 illustrates a schematic diagram of another arrangement mode of the SNC structure according to an exemplary embodiment of the present disclosure;
FIG. 3 illustrates a schematic diagram of a fabrication process of the SNC structure in the related technologies;
FIG. 4 illustrates a schematic diagram of a semiconductor structure according to an embodiment of the present disclosure;
FIG. 5 illustrates a flowchart of a method of fabricating the SNC structure according to an embodiment of the present disclosure;
FIG. 6A to FIG. 6D illustrate schematic diagrams of the process of steps as shown in FIG. 5;
FIG. 7A and FIG. 7B are schematic diagrams illustrating shapes of inclined planes of the SNC structure according to an embodiment of the present disclosure;
FIG. 8A and FIG. 8B are schematic cross-sectional views illustrating shapes of the inclined planes of the SNC structure from another angle according to an embodiment of the present disclosure;
FIG. 9A illustrates schematic diagram I showing an undesirable effect of polycrystalline silicon growth;
FIG. 9B illustrates schematic diagram II showing an undesirable effect of polycrystalline silicon growth; and
FIG. 10 illustrates a schematic diagram of the SNC structure after performing a recess etch process.

### DETAILED DESCRIPTION

Exemplary embodiments will now be described more comprehensively with reference to the accompanying drawings. However, the exemplary embodiments can be embodied in many forms and should not be construed as being limited to the embodiments set forth herein. Rather, these embodiments are provided so that the present disclosure will be thorough and complete, and the concepts of these exemplary embodiments will be fully conveyed to those skilled in the art. The described features, structures, or characteristics may be combined in any suitable manner in one or more embodiments. In the following description, numerous details are provided to give a thorough understanding of the embodiments of the present disclosure. However, those skilled in the art will recognize that the technical solution of the present disclosure may be practiced without one or more of the details described, or that other methods, components, devices, steps, etc. may be employed. In other instances, well-known technical solutions are not shown or described in detail to avoid overwhelming and obscuring aspects of the present disclosure.

Furthermore, the accompanying drawings are merely schematic illustrations of the present disclosure. Same or similar parts are denoted by same reference numbers in the drawings and, thus, a repeated description thereof will be omitted. Some block diagrams shown in the drawings are functional entities and not necessarily to be corresponding to a physically or logically individual entities. These functional entities may be implemented in software form, or implemented in one or more hardware modules or integrated circuits, or implemented in different networks and/or processor apparatuses and/or microcontroller apparatuses.

The exemplary embodiments of the present disclosure will be described in detail below with reference to the accompanying drawings.

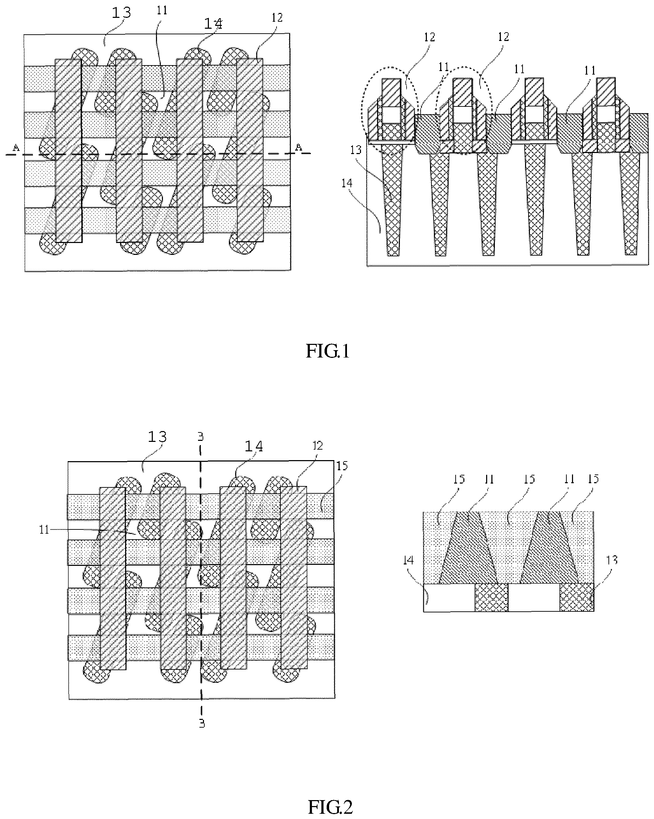

FIG. 1 illustrates a schematic diagram of an arrangement mode of an SNC structure according to an exemplary embodiment of the present disclosure.

The structure on the right half part of the FIG. 1 is a cross-sectional view along an A-A line of the structure as shown on the left half part of the FIG. 1. In a DRAM structure, the A-A line is perpendicular to a bit line (BL) and parallel to a word line (WL). In FIG. 1, a storage node contact (SNC) structure 11 is located between sidewalls of two bit line structures 12 at corresponding positions in two adjacent rows of word lines, and a bottom of the SNC structure 11 is connected to an active region 14 and a shallow trench isolation (STI) structure 13.

FIG. 2 illustrates a schematic diagram of another arrangement mode of the SNC structure according to an exemplary embodiment of the present disclosure.

The structure on the right half part of the FIG. 2 is a cross-sectional view along a B-B line of the structure as shown on the left half part of the FIG. 2. In the DRAM structure, the B-B line is perpendicular to the word line (WL) and is parallel to the bit line (BL). The adjacent SNC structures are isolated by isolation structures 15, the isolation structures 15 include dielectric layer structures. It is to be understood that similar to FIG. 1, the storage node contact (SNC) structure 11 in FIG. 2 is still connected, at the bottom thereof, to the active region 14 and the shallow trench isolation structure 13. It is to be understood that, by shifting the B-B line, cross-sectional positions are different, such that proportions of the active region 14 and the shallow trench isolation structure 13 in the cross section are different. In the embodiments of the present disclosure, for the sake of simplicity, only the regional positions and proportions as shown in FIG. 2 are employed, but the present disclosure is not limited thereto.

FIG. 3 is a schematic diagram showing a process of fabricating the SNC structure in existing technologies.

With reference to FIG. 3, the isolation structures between the SNC structures include bit line structures and dielectric layer sidewalls, and thus it is required to form the dielectric layer sidewalls when fabricating a groove for containing the SNC structures. However, due to larger hardness, generally the dielectric layer sidewalls are difficult to be formed by etching. Therefore, in the related technologies, generally a trench is fabricated (as shown in Step (a)) by etching a sacrificial layer material 31 (which is generally an oxide, such as silicon dioxide, BPSG, BSG, and so on) in the along a B-B line as shown in FIG. 2, and dielectric layer structures 15 are fabricated (as shown in Step (b)) by using a deposition technology. Then, the remaining sacrificial layer material 31 is removed (as shown in Step (c)), and a polycrystalline silicon is deposited between the dielectric layer structures 15 to fabricate the SNC structure 11 (as shown in Step (d)). It is to be understood that there exists isolation structures (such as the isolation structures 12 on the right part of the FIG. 1) including the bit line structures in the front and rear of the viewing direction in the figures, and the isolation structures including the bit line structures generally are formed before the dielectric layer structures 15 are formed. In this technology, since the sacrificial layer material is etched in Step (a), the cross-section of the remaining sacrificial layer material is trapezoid. That is, the SNC structure finally fabricated is also a trapezoidal cross section which is narrow at the top and wide at the bottom, making it difficult to complete good deposition of the polycrystalline silicon. Air gaps generally exist in the SNC structure (as shown in Step (d)).

In view of the forgoing, the embodiments of the present disclosure provide semiconductor structures capable of avoiding a forming of air gaps in the SNC structure.

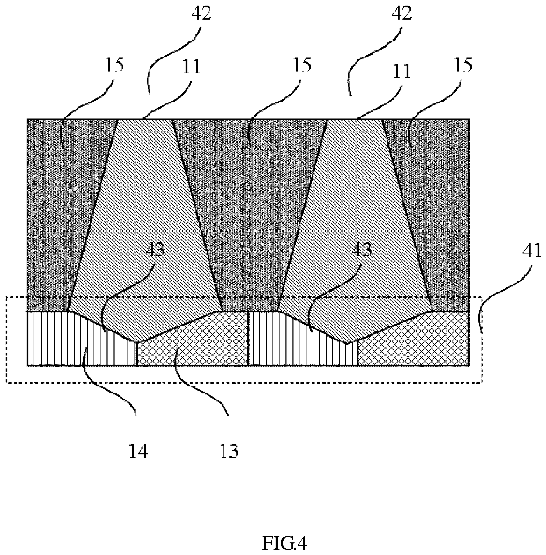

FIG. 4 illustrates a schematic diagram of a semiconductor structure according to an embodiment of the present disclosure.

It is to be noted that FIG. 4 is a cross-sectional view along a B-B line of the structure as shown on the left half part of the FIG. 2, and there exists isolation structures (such as the isolation structures 12 on the right half part of the FIG. 1) including the bit line structures in the front and rear of the viewing direction in the figures.

With reference to FIG. 4, the semiconductor structure 400 may include:
a substrate 41 including active regions 14 and shallow trench isolation regions 13 arranged at intervals from each other;
isolation structures 15 arranged on a surface of the substrate 41;
a plurality of grooves 42 arranged in the isolation structures 15, a bottom of each of the grooves 42 being provided with a first inclined plane 43 formed in the active region 14; and
a conductive plug 11 arranged in each of the grooves 42.

FIG. 4 is a cross-sectional view along a B-B line in FIG. 2, the isolation structures 15 marked in FIG. 4 actually are dielectric layer structures, i.e., the isolation structures 15 on the right half part of FIG. 2. However, those skilled in the art may understand that the isolation structures 15 in the embodiments of the present disclosure further include the bit line structures 12 as shown in FIG. 1, and the bit line structures 12 are in the front or rear of the viewing direction in FIG. 4. That is, the isolation structures 15 in the embodiments of the present disclosure include four sidewall structures such as two adjacent bit line structures and two adjacent dielectric layer structures, to realize encirclement and isolation of the groove 42.

In the embodiment as shown in FIG. 4, a top area of the groove 42 is smaller than a bottom area thereof, and cross-sectional shapes of the plurality of grooves include one or more of a square, a polygon, a circle, or an ellipse. The plurality of grooves 42 are arranged in an array, wherein the array may be an aligned or staggered dot array. It is to be understood that two opposite sidewalls of the groove 42 are formed by the isolation structures including the bit line structures, and the bit line structure is perpendicular to the substrate. Therefore, a length of a top surface of the groove 42 may be equal to that of a bottom surface thereof, or a width of the top surface of the groove 42 may be equal to that of the bottom surface, which is not particularly limited in the present disclosure.

In one embodiment of the present disclosure, an inclination angle of the first inclined plane 43 may be 30°-40°, for example. Of course, on the active region 14 there may also exist another region. A slope of the other region is different from that of the first inclined plane, which may be, for example, a horizontal region (for example, a bottom shape of the SNC structure 11 in the structure on the right half part of FIG. 1). In another embodiment of the present disclosure, the first inclined plane 43 may also be a cambered surface formed in an etching process, which is not particularly limited in the present disclosure.

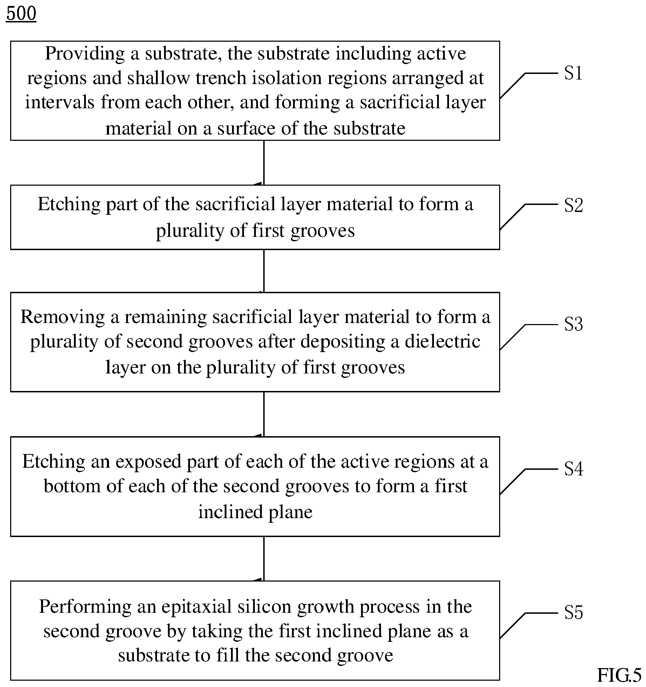

FIG. 5 illustrates a flowchart of a method of fabricating the semiconductor structure as shown in FIG. 4.

With reference to FIG. 5, the method 500 of fabricating the semiconductor structure may include:
Step S1: providing a substrate, the substrate including active regions and shallow trench isolation regions arranged at intervals from each other, and forming a sacrificial layer material on a surface of the substrate;
Step S2: etching part of the sacrificial layer material to form a plurality of first grooves;
Step S3: after depositing a dielectric layer on the first groove, removing the remaining sacrificial layer material to form a plurality of second grooves;
Step S4: etching an exposed part of the active region at a bottom of the second groove to form a first inclined plane; and
Step S5: performing an epitaxial silicon growth process in the second groove by taking the first inclined plane as a substrate to fill the second groove.

In the embodiments of the present disclosure, the sacrificial layer is, for example, an oxide layer, including but not limited to materials such as oxide (such as silicon dioxide), BPSG, BSG, and the like. The first groove is, for example, an inverted trapezoidal groove which is wide at the top and narrow at the bottom, and the second groove is, for example, a trapezoidal groove which is wide at the bottom and narrow at the top. Those of ordinary skill in the art should understand that a non-inverted trapezoidal first groove may also be formed here, wherein a shape of the first groove is determined by factors such as technology means and technological conditions; and the second groove may also be a non-trapezoidal groove, wherein a shape of the second groove is related to the shape of the first groove.

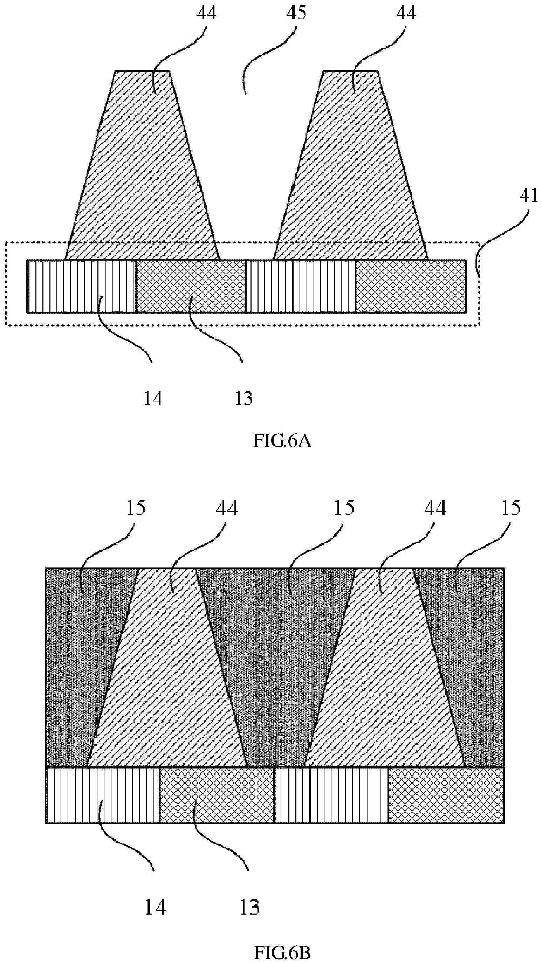

FIG. 6A to FIG. 6D illustrate schematic diagrams of the process of the steps as shown in FIG. 5.

Similar to FIG. 2 and FIG. 4, for the sake of simplicity, the positions and proportions of the active regions and the shallow trench isolation regions in FIG. 6A to FIG. 6D are merely for the purpose of illustration, and are not intended to limit the positions and proportions of the active regions and the shallow trench isolation regions in the actual processes.

Referring to FIG. 6A, similar to Step (a) in FIG. 3, in the embodiments of the present disclosure, the first groove 45 is also etched on the sacrificial layer 44 to make preparations for the subsequent fabrication of the isolation structure. The active region 14 and the shallow trench isolation region 13 are exposed at the bottom of the first groove 45 at the same time. At this moment, the bit line structures in the front or rear of the viewing direction of the figures generally have already been formed. Therefore, the step as shown in FIG. 6A actually refers to filling the sacrificial layer between the bit line structures and then etching the first groove 45 in the sacrificial layer. That is, two sidewalls in the front and rear of the viewing direction of the first groove 45 are perpendicular to each other and are formed by the isolation structures including the bit line structures.

Referring to FIG. 6B, similar to Step (b) in FIG. 3, in the embodiments of the present disclosure, the isolation structures 15 are fabricated in the same way by depositing a dielectric layer, wherein a material of the dielectric layer is, for example, silicon nitride.

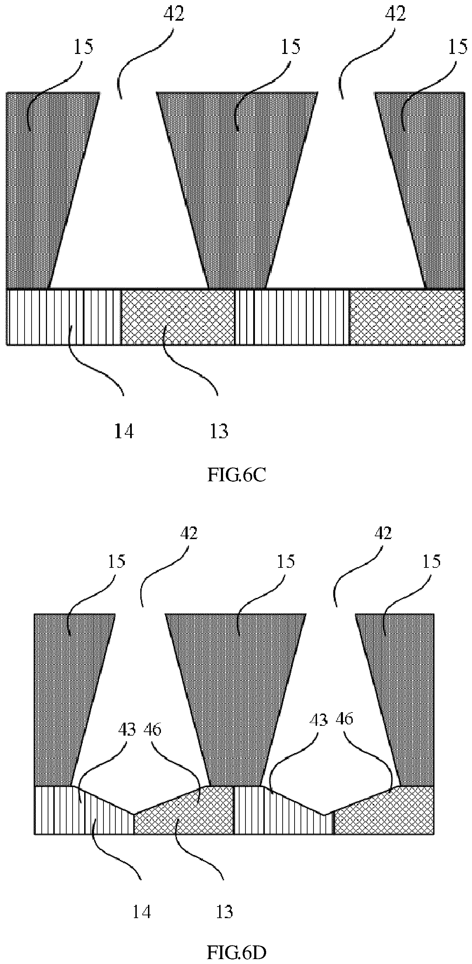

Referring to FIG. 6C, similar to Step (c) in FIG. 3, in the embodiments of the present disclosure, space is created for the fabrication of the SNC also by removing the sacrificial layer 44 to form the second groove 42, and the active region 14 and the shallow trench isolation region 13 are exposed at the bottom of the second groove 42 at the same time. It is to be noted that as can be seen from FIG. 2, as the cross-sectional positions are different (that is, the B-B line is shifted transversely), the proportions of the active region and the shallow trench isolation region exposed at the bottom of the second groove 42 actually are different. Therefore, although the embodiments of the present disclosure merely show one type of exposed state of the active region and the shallow trench isolation region, in practical applications, the active region and the shallow trench isolation region may have many types of exposed states.

Referring to FIG. 6D, the SNC is fabricated by means of an epitaxial silicon growth process. Therefore, for the smooth progress of the epitaxial silicon growth process, the bottom of the second groove 42 is processed. That is, the first inclined plane 43 is fabricated at the bottom of the second groove 42 through a dry etching process or wet etching process, etc. To fabricate the SNC, both the active region and the shallow trench isolation region are exposed at the bottom of the second groove 42 (referring to the structure on the left half part of FIG. 2). The material of the active region generally is monocrystalline silicon, and the material of the shallow trench isolation region generally is oxide (for example, silicon dioxide). The active region and the shallow trench isolation region provide completely different environments for the growth of the epitaxial silicon. In the embodiments of the present disclosure, in this process, the monocrystalline silicon generally grows only on one side of the monocrystalline silicon, and the monocrystalline silicon is hard to grow or grows at a slow rate on one side of the silicon dioxide. Therefore, to provide more crystal orientations for the growth of the monocrystalline silicon and to ensure the growth of the monocrystalline silicon more uniform and more rapid, the first inclined plane 43 is fabricated before the epitaxial silicon growth process.

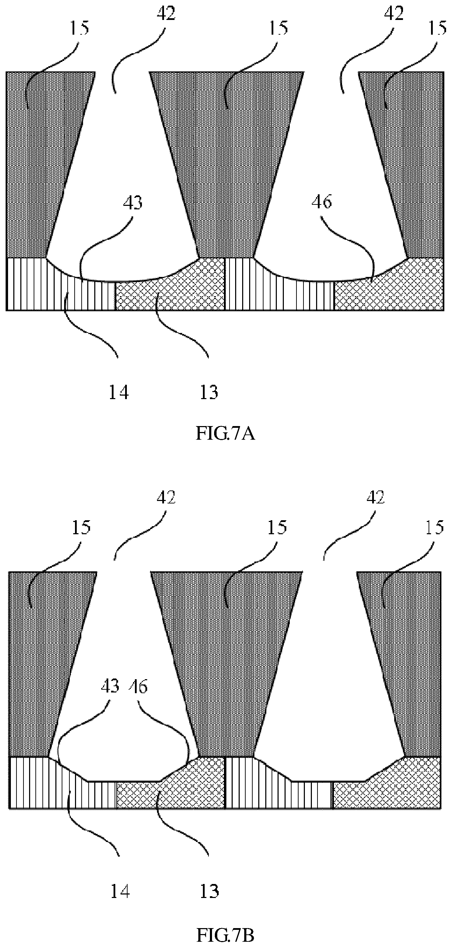

In an exemplary embodiment of the present disclosure, gas for etching the first inclined plane 43 may be, for example, sulfur hexafluoride (SF6). The first inclined plane 43 whose inclination angle is 30°-40° may be etched by controlling parameters such as bias and flow of the etching gas. It is to be noted that in the etching process, generally it is unable to ensure that a perfect plane is etched. Therefore, in the actual fabrication processes, the first inclined plane 43 may also be a cambered surface formed by the etching process, wherein the shape of the cambered surface may be as shown in FIG. 7A. In addition, in some embodiments, the active region also likely has other regions such as planes. That is, an end point of the first inclined plane 43 formed by etching does not coincide with an edge of the active region. In this case, the state of the active region may be as shown in FIG. 7B.

In addition, since the shallow trench isolation region is connected to the active region, it is easy to simultaneously etch the exposed part of the shallow trench isolation region when the inclined plane is etched at the exposed part of the active region. In this case, an etching selectivity may be controlled to be, for example, 1:1 to form the second inclined plane 46. The inclination angle of the second inclined plane 46 is, for example, 20°-60°. Obviously, those skilled in the art should understand that due to process deviation or the etching selectivity not being 1:1, there exists a difference between a height of the shallow trench isolation region and that of the active region after etching. However, to prevent the shallow trench isolation region from greatly differing from the active region in height, the etching selectivity had better not differ greatly, to prevent air gaps from being formed in the epitaxial silicon growth process. Similar to the formation of the first inclined plane 43, the second inclined plane 46 may also be a cambered surface, or the edge of the second inclined plane 46 does not coincide with the edge of the shallow trench isolation region. Reference may be made to FIG. 7A and FIG. 7B respectively for these two states.

It is to be understood that the etching process is conducted for the entire exposed part of the active region and the entire exposed part of the shallow trench isolation region. Therefore, the inclined plane at the bottom of the second groove 42 is actually similar to a bowl shape placed upright. There exists an inclined plane at the bottom of the second groove 42 no matter it is viewed from the cross section along the A-A line in FIG. 1 or it is viewed from the cross section along the B-B line in FIG. 2.

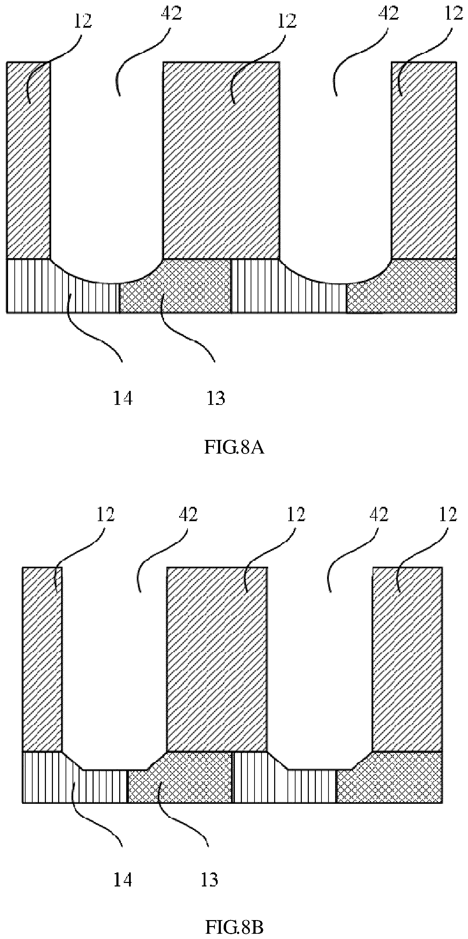

Reference may be made to FIG. 8A and FIG. 8B, viewed from the cross section along the A-A line on the left half part of FIG. 1, the active region 14 and the shallow trench isolation region 13 may have different proportions and different inclined planes.

To prevent the remaining impurities (such as a natural oxide layer and etching residue) (at the positions of 43 or 46 in FIG. 6D) from having a negative effect on electrical properties of the inclined plane and even causing failed growth of the monocrystalline silicon, in some embodiments of the present disclosure, the first inclined plane 43 also may be cleaned in situ by means of dry cleaning of oxides or dry cleaning of removing carbon-based residues, etc., thus the purity of the monocrystalline silicon interface is ensured, so as to obtain high-quality growth effects.

After the in-situ cleaning, the monocrystalline silicon may grow, by taking the inclined plane as the substrate, until the epitaxial silicon is controlled to fill the entire second groove 42 up to form the conductive plug 11 as shown in FIG. 4. In some embodiments, the conductive plug 11 is a storage node contact (SNC) structure. With reference to the right half part of FIG. 1, viewed from the cross section of the A-A line, there also exists an inclined plane below the conductive plug 11 (i.e., the SNC structure 11) as shown on the right half part of FIG. 1.

It is to be noted that the shape of the grown monocrystalline silicon often is not ideal (as shown in FIG. 7), in another embodiment of the present disclosure, a growth selectivity of the polycrystalline silicon may be reduced in step S4, and a growth rate of that may be increased. For example, the growth selectivity may be reduced by setting an appropriate flow of hydrochloric acid. Preferably, the concentration of the hydrochloric acid is, for example, 150 sccm ± 30%. Increase of the flow of the hydrochloric acid may inhibit the growth of polycrystals and tend to grow on the surface of a monocrystal. Decrease of the flow of the hydrochloric acid may increase the growth rate of the polycrystalline silicon and increase the yield. Therefore, it is required to seek the most appropriate flow range of the hydrochloric acid to ensure the quality of the monocrystal and to increase the yield. Therefore, the above range is set in the embodiments of the present disclosure.

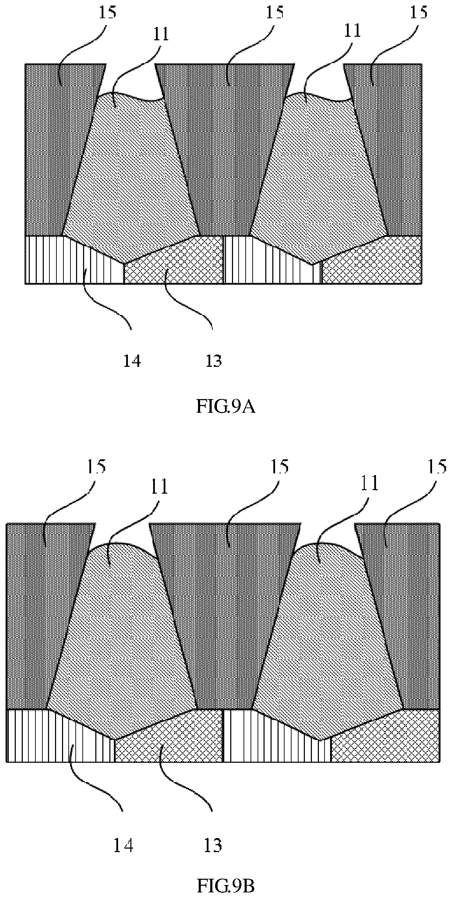

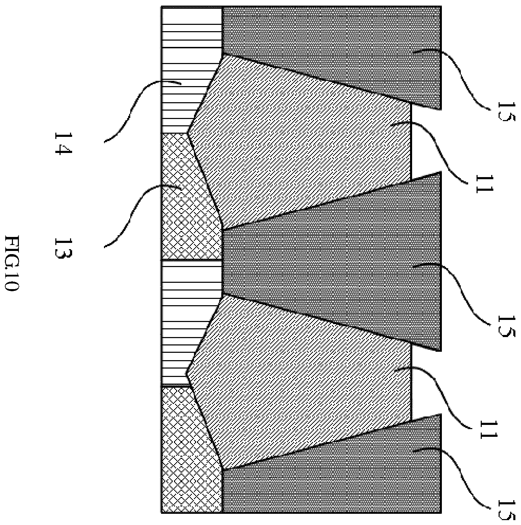

In addition, the monocrystalline silicon and the polycrystalline silicon may grow at the same time, and thus their shapes are not easy to control, as shown in FIG. 9A or FIG. 9B. In this case, the polycrystalline silicon may be removed by means of recess etch such as a wet process to only leave the monocrystal silicon, and the shape of the top of the monocrystalline silicon may be trimmed to a plane roughly (as shown in FIG. 10), and the length of the conductive plug is adjusted for the subsequent metal connection process.

In one embodiment, the conductive plug is a storage node contact. After the storage node contact is formed, a capacitive landing pad made of a metal material may be formed on the storage node contact for subsequent fabrication of a capacitor on the interface platform. The connection of the landing pad made of the metal material onto the storage node contact belongs to the fabrication of a metal-semiconductor contact structure. Therefore, in another embodiment of the present disclosure, after filling the second groove, metal may be deposited on the surface of the conductive plug 11.

In this case, the above-mentioned landing pad is in contact with the monocrystalline silicon, which is a case where metal is in contact with the monocrystalline silicon, similar to the case of contact between a source and a drain of a transistor in a peripheral circuit. Meanwhile, a metallization process is implemented, and optimal process conditions may be achieved at the same time, which makes process condition requirements simpler, improves the performance of the contact structure, and allows a contact resistance between the metal and the monocrystalline silicon to be smaller under the condition of lower fabrication costs.

In summary, in the embodiments of the present disclosure, the monocrystalline silicon is grown at the bottom of the groove to fabricate a storage node contact structure (SNC structure) that fills the groove up, which can avoid degradation of electrical properties caused by air gaps formed in the SNC structure due to deposition of the polycrystalline silicon in the related technologies. In addition, by fabricating an inclined plane of the monocrystalline silicon at the bottom of the groove and growing the monocrystalline silicon on the inclined plane of the monocrystalline silicon, problems such as uneven growth and low growth rate caused in the growth process of the monocrystalline silicon may be avoided, and a fabrication efficiency can be effectively enhanced while improving the yield rate.

It is to be noticed that although a plurality of modules or units of the device for action execution have been mentioned in the above detailed description, this partition is not compulsory. Actually, according to the embodiments of the present disclosure, features and functions of two or more modules or units as described above may be embodied in one module or unit. Reversely, features and functions of one module or unit as described above may be further embodied in more modules or units.

Other embodiments of the present disclosure will be apparent to those skilled in the art from consideration of the specification and practice of the invention disclosed here. This disclosure is intended to cover any variations, uses, or adaptations of the present disclosure following the general principles thereof and including such departures from the present disclosure as common knowledge or customary practice in the art. It is intended that the specification and embodiments be considered as exemplary only, with the scope of the present disclosure being indicated by the claims.

### Industrial Applicability

According to the embodiments of the present disclosure, an inclined plane is provided on the exposed part of the active region at the bottom of the groove containing the SNC structure, and the polycrystalline silicon is grown inside the groove by taking the inclined plane as a substrate. In this way, the SNC structure without air gap can be quickly formed, a component failure rate can be reduced, and a yield rate can be enhanced.

## Claims

1. A semiconductor structure, comprising a substrate (41) and a plurality of isolation structures (15); the substrate (41) comprises active regions (14) and shallow trench isolation regions (13) arranged at intervals from each other; the plurality of isolation structures (15) are arranged on a surface of the substrate (41);
a plurality of grooves (42), arranged between the plurality of isolation structures (15), a bottom of each of the grooves (42) being provided with a first inclined plane (43), and the first inclined plane (43) being formed in each of the active regions (14); and
a conductive plug (11), arranged in each of the grooves (42);
**characterized in that**
the conductive plug (11) is epitaxially grown on the first inclined plane (43) and formed in each of the grooves (42), and a top area of the conductive plug (11) is smaller than a bottom area of the conductive plug (11).

2. The semiconductor structure according to claim 1, **characterized in that** a top area of each of the grooves (42) is smaller than a bottom area of the groove (42).

3. The semiconductor structure according to claim 1, **characterized in that** an inclination angle of the first inclined plane (43) ranges from 30° to 40°.

4. The semiconductor structure according to claim 1, **characterized in that** a bottom of each of the grooves (42) is further provided with a second inclined plane (46), and the second inclined plane (46) is formed on each of the shallow trench isolation regions (13).

5. The semiconductor structure according to claim 4, **characterized in that** an inclination angle of the second inclined plane (46) ranges from 20° to 60°.

6. The semiconductor structure according to claim 1, **characterized in that** the plurality of isolation structures (15) comprise dielectric layer structures.

7. The semiconductor structure according to claim 1, **characterized in that** shapes of cross sections of the plurality of grooves (42) comprise one or more of a polygon, a circle, or an ellipse.

8. The semiconductor structure according to claim 7, **characterized in that** the plurality of grooves (42) are arranged in an array.

9. The semiconductor structure according to claim 1, **characterized in that** the first inclined plane (43) is a cambered surface.

10. A method of fabricating a semiconductor structure, comprising:
providing a substrate (41), the substrate (41) comprising active regions (14) and shallow trench isolation regions (13) arranged at intervals from each other;
forming a sacrificial layer material (31) on a surface of the substrate (41);
etching part of the sacrificial layer material (31) to form a plurality of first grooves (45);
removing a remaining sacrificial layer material (31) to form a plurality of second grooves (42) after depositing a dielectric layer on the plurality of first grooves (45);
etching an exposed part of each of the active regions (14) at a bottom of each of the second grooves (42) to form a first inclined plane (43); and
performing an epitaxial silicon growth process on the first inclined plane (43) to form a conductive plug (11) in each of the second grooves (42), wherein a top area of the conductive plug (11) is smaller than a bottom area of the conductive plug (11).

11. The method according to claim 10, **characterized in that** an inclination angle of the first inclined plane (43) ranges from 30° to 40°.

12. The method according to claim 10, **characterized in that** the step of etching an exposed part of each of the active regions (14) at a bottom of each of the second grooves (42) to form a first inclined plane (43) further comprises:
simultaneously etching an exposed part of each of the shallow trench isolation regions (13) adjacent to the exposed part of each of the active regions (14) to form a second inclined plane (46).

13. The method according to claim 12, **characterized in that** an etching selectivity of the exposed part of each of the active regions (14) with respect to an etching selectivity of the exposed part of each of the shallow trench isolation regions (13) is 1:1.

14. The method according to claim 10, **characterized in that** further comprising:
depositing metal on a surface of the conductive plug (11).

15. The method according to claim 14, **characterized in that** further comprising:
before depositing the metal, removing, from the conductive plug (11), a polycrystalline silicon by using a wet process to remain only a monocrystalline silicon, and trimming a top of filled silicon to be a flat plane.

## Patentansprüche

1. Halbleiterstruktur, umfassend ein Substrat (41) und eine Vielzahl von Isolationsstrukturen (15); wobei das Substrat (41) aktive Bereiche (14) und flache Grabenisolationsbereiche (13) umfasst, die in Abständen voneinander angeordnet sind; wobei die Vielzahl von Isolationsstrukturen (15) auf einer Oberfläche des Substrats (41) angeordnet ist;
eine Vielzahl von Rillen (42), die zwischen der Vielzahl von Isolationsstrukturen (15) angeordnet sind, wobei ein Boden von jeder der Rillen (42) mit einer ersten geneigten Ebene (43) versehen ist und die erste geneigte Ebene (43) in jedem der aktiven Bereiche (14) gebildet ist; und
einen leitenden Stecker (11), der in jeder der Rillen (42) angeordnet ist; **dadurch gekennzeichnet, dass**
der leitende Stecker (11) epitaxial auf der ersten geneigten Ebene (43) gewachsen ist und in jeder der Rillen (42) gebildet ist, und eine obere Fläche des leitenden Steckers (11) kleiner ist als eine untere Fläche des leitenden Steckers (11).

2. Halbleiterstruktur nach Anspruch 1, **dadurch gekennzeichnet, dass** eine obere Fläche von jeder der Rillen (42) kleiner ist als eine untere Fläche der Rille (42).

3. Halbleiterstruktur nach Anspruch 1, **dadurch gekennzeichnet, dass** ein Neigungswinkel der ersten geneigten Ebene (43) in einem Bereich von 30° bis 40° ist.

4. Halbleiterstruktur nach Anspruch 1, **dadurch gekennzeichnet, dass** ein Boden von jeder der Rillen (42) ferner mit einer zweiten geneigten Ebene (46) versehen ist, und die zweite geneigte Ebene (46) auf jedem der flachen Grabenisolationsbereiche (13) gebildet ist.

5. Halbleiterstruktur nach Anspruch 4, **dadurch gekennzeichnet, dass** der Neigungswinkel der zweiten geneigten Ebene (46) in einem Bereich von 20° bis 60° ist.

6. Halbleiterstruktur nach Anspruch 1, **dadurch gekennzeichnet, dass** die Vielzahl von Isolationsstrukturen (15) dielektrische Schichtstrukturen umfassen.

7. Halbleiterstruktur nach Anspruch 1, **dadurch gekennzeichnet, dass** die Formen von Querschnitten der Vielzahl von Rillen (42) eines oder mehrere von einem Vieleck, einem Kreis oder einer Ellipse umfassen.

8. Halbleiterstruktur nach Anspruch 7, **dadurch gekennzeichnet, dass** die Vielzahl von Rillen (42) in einem Muster angeordnet sind.

9. Halbleiterstruktur nach Anspruch 1, **dadurch gekennzeichnet, dass** die erste geneigte Ebene (43) eine abgekantete Fläche ist.

10. Verfahren zum Herstellen einer Halbleiterstruktur, umfassend:
Bereitstellen eines Substrats (41), das Substrat (41) umfassend aktive Bereiche (14) und flache Grabenisolationsbereiche (13), die in Abständen voneinander angeordnet sind;
Bilden eines Opferschichtmaterials (31) auf einer Oberfläche des Substrats (41);
Ätzen eines Teils des Opferschichtmaterials (31), um eine Vielzahl von ersten Rillen (45) zu bilden; Entfernen eines verbleibenden Opferschichtmaterials (31), um eine Vielzahl von zweiten Rillen (42) zu bilden, nachdem eine dielektrische Schicht auf der Vielzahl von ersten Rillen (45) aufgebracht wurde;
Ätzen eines freiliegenden Teils von jedem der aktiven Bereiche (14) an einem Boden von jeder der zweiten Rillen (42), um eine erste geneigte Ebene (43) zu bilden; und
Ausführen eines epitaktischen Siliziumwachstumsprozesses auf der ersten geneigten Ebene (43), um einen leitenden Stecker (11) in jeder der zweiten Rillen (42) zu bilden, wobei eine obere Fläche des leitenden Steckers (11) kleiner ist als eine untere Fläche des leitenden Steckers (11).

11. Verfahren nach Anspruch 10, **dadurch gekennzeichnet, dass** ein Neigungswinkel der ersten geneigten Ebene (43) in einem Bereich von 30° bis 40° ist.

12. Verfahren nach Anspruch 10, **dadurch gekennzeichnet, dass** der Schritt eines Ätzens eines freiliegenden Teils von jedem der aktiven Bereiche (14) an einem Boden jeder der zweiten Nuten (42) zum Bilden einer ersten geneigten Ebene (43) ferner Folgendes umfasst:
gleichzeitiges Ätzen eines freiliegenden Teils von jedem der flachen Grabenisolationsbereiche (13), der an den freiliegenden Teil jedes der aktiven Bereiche (14) angrenzt, um eine zweite geneigte Ebene (46) zu bilden.

13. Verfahren nach Anspruch 12, **dadurch gekennzeichnet, dass** eine Ätzselektivität des freiliegenden Teils von jedem der aktiven Bereiche (14) in Bezug auf eine Ätzselektivität des freiliegenden Teils von jedem der Grabenisolationsbereiche (13) mit flachem Graben 1:1 ist.

14. Verfahren nach Anspruch 10, **dadurch gekennzeichnet, dass** es ferner Folgendes umfasst: Aufbringen von Metall auf einer Oberfläche des leitenden Steckers (11).

15. Verfahren nach Anspruch 14, **dadurch gekennzeichnet, dass** ferner Folgendes umfassend:
vor Aufbringen des Metalls, Entfernen eines polykristallinen Siliziums aus dem leitenden Stecker (11) durch Verwendung eines Nassverfahrens, sodass nur ein monokristallines Silizium verbleibt, und Zuschneiden der Oberseite des gefüllten Siliziums, sodass eine ebene Fläche entsteht.

## Revendications

1. Structure semi-conductrice, comprenant un substrat (41) et une pluralité de structures d'isolation (15) ; le substrat (41) comprend des régions actives (14) et des régions d'isolation par tranchées peu profondes (13) disposées à des intervalles les unes des autres ; la pluralité de structures d'isolation (15) sont disposées sur une surface du substrat (41) ;
une pluralité de rainures (42), disposées entre la pluralité de structures d'isolation (15), un fond de chacune des rainures (42) étant pourvu d'un premier biseau (43), et le premier biseau (43) étant formé dans chacune des régions actives (14) ; et
une fiche conductrice (11), disposée dans chacune des rainures (42) ; **caractérisée en ce que**
la fiche conductrice (11) est produit par croissance épitaxiale sur le premier biseau (43) et formée dans chacune des rainures (42), et une zone supérieure de la fiche conductrice (11) est plus petite qu'une zone inférieure de la fiche conductrice (11).

2. Structure semi-conductrice selon la revendication 1, **caractérisée en ce qu'**une zone supérieure de chacune des rainures (42) est plus petite qu'une zone inférieure de la rainure (42).

3. Structure semi-conductrice selon la revendication 1, **caractérisée en ce qu'**un angle d'inclinaison du premier biseau (43) est de 30° à 40°.

4. Structure semi-conductrice selon la revendication 1, **caractérisée en ce qu'**un fond de chacune des rainures (42) est en outre pourvu d'un second biseau (46), et **en ce que** le second biseau (46) est formé sur chacune des régions d'isolation par tranchées peu profondes (13).

5. Structure semi-conductrice selon la revendication 4, **caractérisée en ce qu'**un angle d'inclinaison du second biseau (46) est de 20° à 60°.

6. Structure semi-conductrice selon la revendication 1, **caractérisée en ce que** la pluralité de structures d'isolation (15) comprend des structures de couches diélectriques.

7. Structure semi-conductrice selon la revendication 1, **caractérisée en ce que** les formes des sections transversales de la pluralité de rainures (42) comprennent un ou plusieurs d'un polygone, un cercle ou une ellipse.

8. Structure semi-conductrice selon la revendication 7, **caractérisée en ce que** la pluralité de rainures (42) est disposée en réseau.

9. Structure semi-conductrice selon la revendication 1, **caractérisée en ce que** le premier biseau (43) est une surface bombée.

10. Procédé de fabrication d'une structure semi-conductrice, comprenant :
la fourniture d'un substrat (41), le substrat (41) comprenant des régions actives (14) et des régions d'isolation par tranchées peu profondes (13) disposées à des intervalles les unes des autres ;
la formation d'un matériau de couche sacrificielle (31) sur une surface du substrat (41) ;
la gravure d'une partie du matériau de couche sacrificielle (31) pour former une pluralité de premières rainures (45) ; le retrait du matériau de couche sacrificielle (31) restant pour former une pluralité de secondes rainures (42) après avoir déposé une couche diélectrique sur la pluralité de premières rainures (45) ;
la gravure d'une partie exposée de chacune des régions actives (14) au fond de chacune des secondes rainures (42) pour former un premier biseau (43) ; et
la réalisation d'un processus de croissance épitaxiale sur le premier biseau (43) pour former une fiche conductrice (11) dans chacune des secondes rainures (42), dans lequel une zone supérieure de la fiche conductrice (11) est plus petite qu'une zone inférieure de la fiche conductrice (11).

11. Procédé selon la revendication 10, **caractérisé en ce que** l'angle d'inclinaison du premier biseau (43) est de 30° à 40°.

12. Procédé selon la revendication 10, **caractérisé en ce que** l'étape de gravure d'une partie exposée de chacune des régions actives (14) au fond de chacune des secondes rainures (42) pour former un premier biseau (43) comprend en outre :
la gravure simultanée d'une partie exposée de chacune des régions d'isolation par tranchées peu profondes (13) adjacente à la partie exposée de chacune des régions actives (14) pour former un second biseau (46).

13. Procédé selon la revendication 12, **caractérisé en ce qu'**une sélectivité de gravure de la partie exposée de chacune des régions actives (14) par rapport à une sélectivité de gravure de la partie exposée de chacune des régions d'isolation par tranchées peu profondes (13) est de 1:1.

14. Procédé selon la revendication 10, **caractérisé en ce qu'**il comprend en outre : le dépôt de métal sur une surface de la fiche conductrice (11).

15. Procédé selon la revendication 14, **caractérisé en ce qu'**il comprend en outre :
avant le dépôt du métal, le retrait, de la fiche conductrice (11), d'un silicium polycristallin en utilisant un procédé humide pour ne conserver qu'un silicium monocristallin, et la découpe de la partie supérieure du silicium rempli pour en faire un plan plat.
